# EUROPEAN PATENT SPECIFICATION

(11) **EP 4 586 424 B1**
(45) Date of publication and mention of the grant of the patent: **22.04.2026**
(21) Application number: 24218199.8
(22) Date of filing: 06.12.2024
(51) Int. Cl.: H02G 3/08, G08B 29/04, H02G 3/10, H02G 3/14

(54) **SURFACE-MOUNTABLE JUNCTION BOX**
OBERFLÄCHENMONTIERBARE ANSCHLUSSDOSE
BOÎTE DE JONCTION MONTABLE EN SURFACE

(30) Priority: 09.01.2024 UA 202400148
(43) Date of publication of application: 16.07.2025
(73) Proprietor: AJAX SYSTEMS CYPRUS HOLDINGS LTD, 2007 Strovolos Nicosia (CY)
(72) Inventor: REZNICHENKO, Anton, 03056 Kyiv (UA); KUPCHENKO, Bohdan, 04116 Kyiv (UA)
(74) Representative: AOMB Polska Sp. z.o.o.

(56) References cited:
- US-A1- 2004 094 318
- US-A1- 2007 040 674
- US-A1- 2015 303 667

## Description

### FIELD OF THE INVENTION

The claimed invention relates to a field of electrical engineering and concerns a connection armature, in particular, a junction box that may be used to receive compatible modules of a wired network, preferably, of a room security system network.

### PRIOR ART

Junction boxes for splitting and/or joining wires have become popular after the creation of wired communications and are still used. Their purpose is to distribute electrical loads and protect wires' joints against mechanical damage and external influences. Electrical junction boxes differ in their mounting method and may be internal and external. The internal boxes are mounted directly within a wall, a ceiling or a floor, while surface-mountable boxes are correspondingly mounted on them.

With the technology development, both in order to avoid costs for laying cables and because of a need for an intelligent use of room space and in case of special requirements regarding positioning of elements of the security system relative to other devices arranged in the room, technologies for connecting wired components of the networks to modules such as expansion modules, concentrators (hubs), commutators (switches), etc., while connecting them to one or more trunk cables, are used increasingly frequently. The modules are used depending on a purpose in order to increase the functionality of power lines and to increase individual wired zones to ensure communication between network elements. The modules may be both wired modules and battery-powered modules. In turn, it may be required that these modules are centralized in a single location and provided with physical protection against any damages and unauthorized intervention.

Thus, there is a crucial need in the advancement of junction boxes and setting them for mounting and ensuring a reliable operation of the modules of network systems, in particular, security systems.

Patent US7566829B2 dated July 28, 2009 discloses a junction box for holding an electrical component, the box comprises a base and a cover that are interconnectable. The base comprises elements for its positioning when mounting on a fastening surface such as openings for fixing parts which are arranged in corresponding positions on its circumferential surface. An inner space for arranging the electrical component and laying a cable is provided between the base and the cover. The electrical component such as a fuse, a relay, a tributary circuit, etc., being connected via a bus, is mounted in an additional housing that acts as a holding element and an anti-intervention element. The additional housing is mounted on a pair of guiding rails on the base, and the rails must correspond to slots provided therein. The cables of the electrical component are brought out from the additional housing to a box space and laid down on the guides between the base and the cover, and their curvature ensures to change a direction of laying/bringing out the cable to the opening in the box. A drawback of this junction box is restriction of possibility of arrangement of electrical components therein both in terms of quantity and direction, since the positioning element, i.e., the additional housing, does not imply any variability. Besides, it implies only physical protection against intervention by complicating the access to the electrical component, however, there is no alarm effect.

Also, an invention application WO2022226160A1 dated October 27, 2022 discloses a junction box comprising a base that is mountable on a mounting surface, and the base comprises a mounting part having a penetration zone, a slot that delimits the penetration zone and provided in a lower surface of the base, and a spacer having a corresponding shape for arrangement in the slot in such a way that when the base is arranged on the mounting surface, the spacer covers an empty space in the spacer relative to the mounting surface. A drawback of this technical solution is that the mounting surface for mounting the junction box thereon must have smooth edges. It restricts use of the box in some cases, e.g., when the mounting surface has irregularities or protrusions. Except for the physical protection against intervention that complicates the access to the electrical component, the junction box has no additional functions that could inform about an intervention attempt.

Provision of the junction box with an alarm system as well as ensuring its versatility for arrangement of various modules are disclosed in patent GB2563579B dated January 19, 2022, where an inner space of a base of the box is provided with locations for arrangement of the module thereon, the module may comprise or carry an electrical device, in particular, a branched wired security system. This space is formed by fastening elements, e.g., protrusions, which corresponding openings on the module may be connected to. The base is configured to be fastened on a surface, preferably, a wall, it is equipped with locations for laying the cables from the system to the elements of the module, and it comprises a protective cover that is provided with fixation openings for a fastener to fasten to the base. The box is equipped with a device for protection against unauthorized access, the device is represented by a pair of electrical contacts that are connected in a location of the opening for fastening the cover to the base, the contacts are configured to be closed and to generate an alarm signal via components of the security system, if there is an attempt to open the box with tools other than user tools that have authentication contacts. This solution is rather complex, since it is required to manufacture special tools for mounting the box and to create an individual alarm system for them, as well as to ensure a precise correspondence between the fastening elements of the base and the module. Furthermore, the protection against unauthorized access disclosed in this solution protects the housing of the box only in case of its opening, but it does not imply any alarm protection against a full dismounting of the box from the mounting surface that may be used for malicious purposes. Other relevant documents are US2004/094318A1 and US2007/040674A1.

In view of the prior art, it follows that a need in such devices is rather high, but the structures of the junction boxes bear a number of drawbacks that affect their operation efficiency. Therefore, there is a need in creation of a junction box that could be mounted in a precise, quick, simple and reliable way, where electrical components could be arranged in a maximum versatile way, and a protection against sabotage or vandalism could be more efficient.

### SUMMARY OF THE INVENTION

Embodiments of the subject invention provide a junction box structure that is protected against external intervention and that could be used by equipping it with means for mounting one or more compatible modules and means for controlling mounting precision, while minimizing use of supplemental tools.

Certain embodiments provide a surface-mountable junction box that comprises a base with elements for its positioning during mounting, where an inner space of the base is provided with locations for mounting at least one module of a branched wired security system, and the base is provided with locations for laying cables. The box comprises a protective cover that is configured to be connected to the base and a protective element for protecting against an unauthorized intervention. According to the claimed invention, the protective element for protecting against the unauthorized intervention is a tamper board having a ribbon cable that is configured to be connected to one of the security system modules that is arranged in the box. The tamper board is mounted in a space between one of side walls and an end wall of the base, while ensuring its firm abutment to the protective cover and to the end wall of the base, and said part of the base is provided with a weak section line along a perimeter of the mounting location of the tamper board. The locations for mounting at least one security system module represent a space that is delimited by guides with mechanical locks. The positioning elements are through openings for a fastener, while protrusions are arranged along their perimeter on an external part of the base. Therewith, the weak section line in the mounting location of the tamper board on the base is provided around one of the openings for the fastener.

An achieved technical effect is an optimization of use of the space in the housing of the box for mounting one or more compatible modules, simplicity and convenience of their mounting and fixation, reliable protection against any unauthorized intervention in case of any attempt to remove the entire structure from the fastener, separation from the mounting surface or in case of attempt to remove the cover, a possibility of precise mounting on the fastening surface, thereby ensuring a correct positioning of the box even on a non-perfectly flat surface in a selected mounting location.

In an exemplary embodiment, the tamper board comprises one tamper that is mounted in an abutment zone of the protective cover. One tamper is sufficient for activation in all mentioned cases of unauthorized access, since both the cover removal and the box dismounting attempt will result in a breakage of the weak part of the base and, thus, in a shift of the tamper board, activation of the tamper and formation of a corresponding signal.

However, in order the security system could detect signals that are generated in case of the cover opening or the box dismounting attempt, in one of possible exemplary embodiments, there are two tampers, where one tamper is provided in the abutment zone of the protection cover, while another tamper is provided in the abutment zone between the board and the end wall of the base.

In another exemplary embodiment, the junction box comprises a bubble level that is fastened in an inner part of the base as an additional positioning element for checking an inclination angle of the box planes during mounting. It significantly simplifies the mounting process of the box, particularly, in conditions of high requirements as to positioning of the box within rooms both based on requirements of its arrangement relative to other devices that are arranged within the room and based on requirements regarding a visual appearance of the elements of the security system within the room interior.

Therewith, in a possible exemplary embodiment, the locations for laying the cables are arranged in the side walls of the base and made as recesses for drilling openings and as a through perforation in the end wall of the base. The perforated part is necessary for laying the cables through a rear side of the box, while drilling locations are provided for laying the cables sideways, from the bottom or from the top.

In another possible exemplary embodiment, the inner surface of the base is provided with protruding loops for a tightening fastener, and the loops may be used for convenient laying and reliable fastening of the cables.

In another possible exemplary embodiment, the inner surface of at least one side wall of the base is provided with rectangular protruding elements that act as battery holders for battery-powered modules, and upper edges of the protruding elements are equipped with openings for the tightening fastener for additional fixation of the batteries in order to avoid their unintentional shift.

In another possible exemplary embodiment, the guides with the locks are arranged in parallel to each other in at least one row, while the locks are configured to mount removable holders. Owing to this structural design, it is possible to vary a distance between elements for holding the modules and a number of the holding elements depending on dimensions, weight and configuration of the modules.

In another possible exemplary embodiment, the inner surface of the cover is provided with at least one abutment protrusion that allows further fixation of the module position in the box, particularly, if it is fastened to the ceiling.

In another possible exemplary embodiment, transverse reinforcing ribs are provided at least along an inner perimeter of the base and the protective cover, the reinforcing ribs ensure rigidity of docking surfaces of the cover and the base.

Furthermore, in another exemplary embodiment, the side walls of the base and of the cover have profiled docking surfaces that are configured to abut to each other in two positions turned by an angle of 180 degrees, while the cover fastening elements are captive screws. The presence of the docking surfaces and the captive screws ensures firm abutment of the cover to the base and temporary retainment of the cover until it is finally fixed on the base. Therewith, the profiling of the docking surfaces allows to mount the base of the box in several positions, thereby expanding a variability of both fixation on the mounting surface and an internal arrangement of the modules.

### BRIEF DESCRIPTION OF THE DRAWINGS

In order to provide more complete understanding of the claimed invention and advantages thereof, the following description provides an explanation of possible exemplary embodiments thereof with a reference to figures of the appended drawings, wherein identical designations denote identical parts, and which illustrate the following:
Fig. 1 illustrates an exploded view of the junction box;

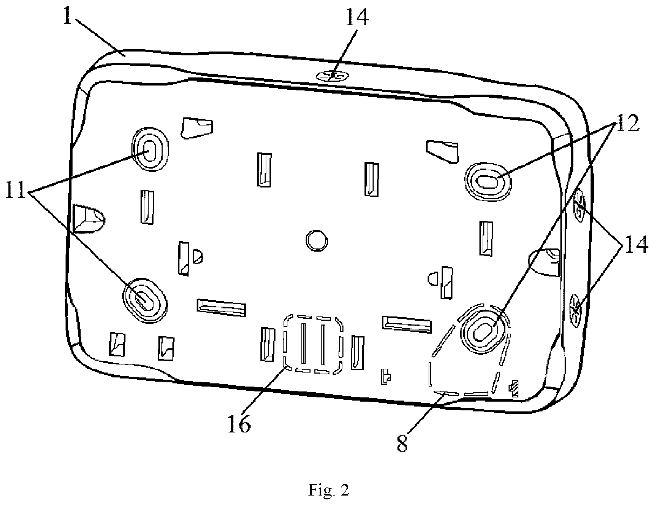

Fig. 2 illustrates an external view of the base of the junction box;

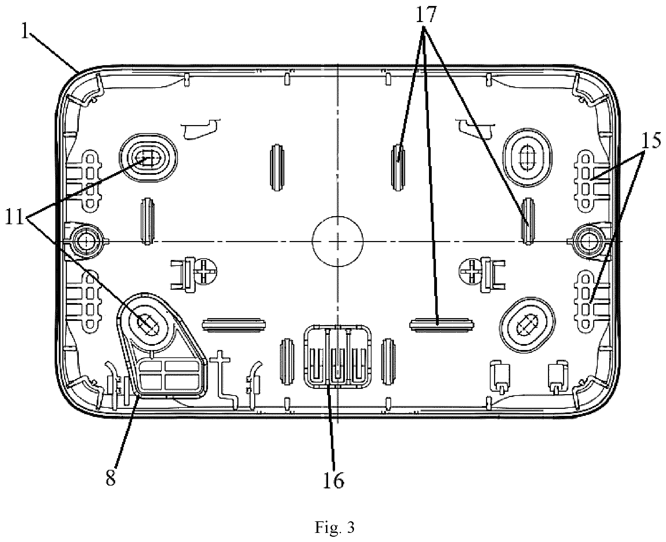

Fig. 3 illustrates an internal view of the base of the junction box;

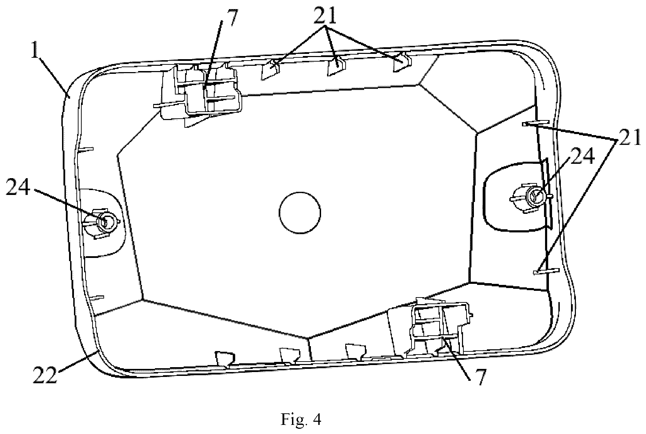

Fig. 4 illustrates an internal view of the cover of the junction box;
Fig. 5 illustrates a cross-sectional view of the base of the junction box;

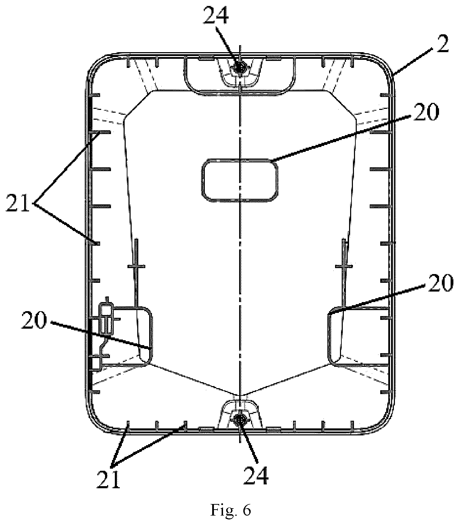

Fig. 6 illustrates an internal view of the cover of the junction box in a possible exemplary embodiment;

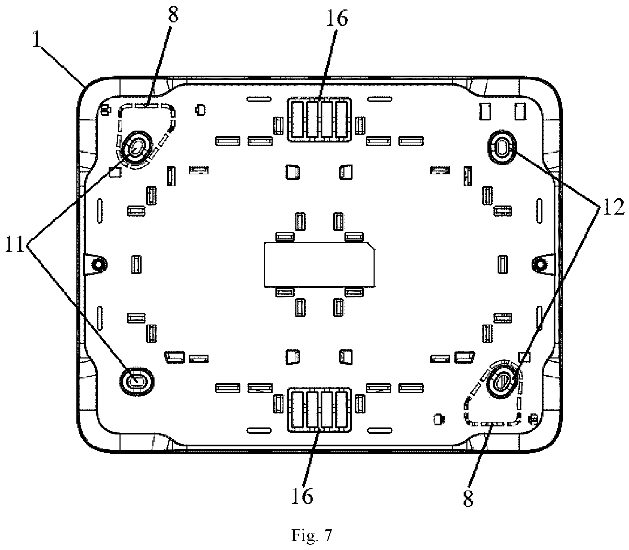

Fig. 7 illustrates an external view of the base of the junction box in a possible exemplary embodiment;
Fig. 8 illustrates an exploded view of the junction box with the modules;
Fig. 9 illustrates the removable holders.

### DETAILED DESCRIPTION OF THE INVENTION

A surface-mountable junction box comprises a base 1 and a cover 2. The base is provided with a location 3 for a tamper board 4 with at least one tamper 5 arranged thereon. The mounting location 3 may be formed as a pair of supporting protrusions or a delimiting lip that ensures orthogonal mounting of the tamper board relative to the cover 2 and to the base 1. Therewith, a configuration of the board 4 and an inner side of the cover 2 form a firm abutment location 7 between the cover 2 and the tamper 5. Also, the tamper board 4 firmly abuts to the base 1 in a location that is delimited by a weak section line 8, where an additional tamper 5 may be mounted. The board 4 is equipped with a ribbon cable 6 that may be fastened to a terminal of one of modules 25 mounted in the box and it may transmit an alarm signal about an intervention into an integrity of the box to any device of a security system having a line that is branched by said module.

The base 1 has positioning elements for its positioning during mounting, the positioning elements are through openings 11 for a fastener, while protrusions 12 are arranged along their perimeter on an external part of the base. Therewith, the weak section line 8 is provided around at least one of openings 11, thereby increasing a probability that the tamper 5 will be activated, if there is an attempt to remove the junction box from the fastener. Width of the openings 11 and height of the protrusions 12 allow to mount the base 1 precisely by adjusting a mounting depth or angle of the fastening elements, thereby allowing to mount the junction box on a non-perfectly flat surface, while the protrusions, during the mounting, additionally act as supporting elements which inhibit the base 1 from sliding along the fastening surface during the mounting. A bubble level 13 may be fastened in an inner part of the base 1 as an additional positioning element for checking an inclination angle of planes of the box, thereby enhancing convenience and precision of mounting the box to a support surface.

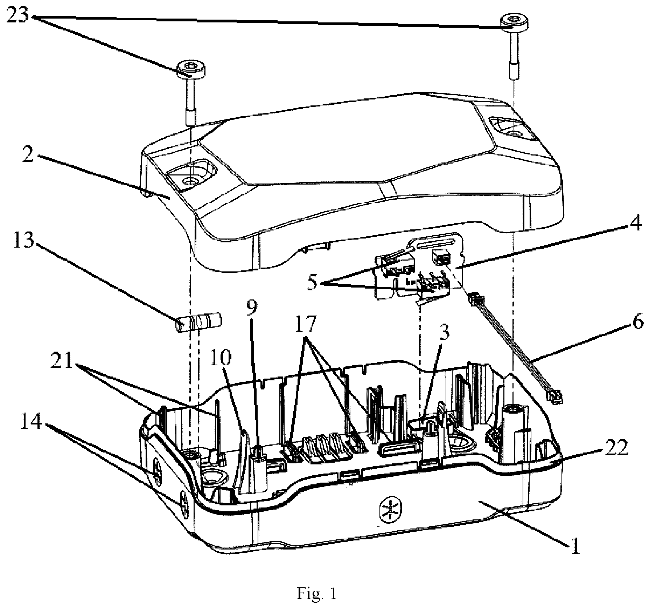

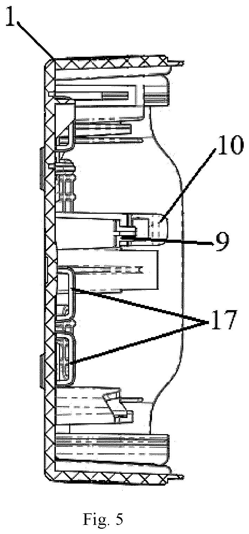

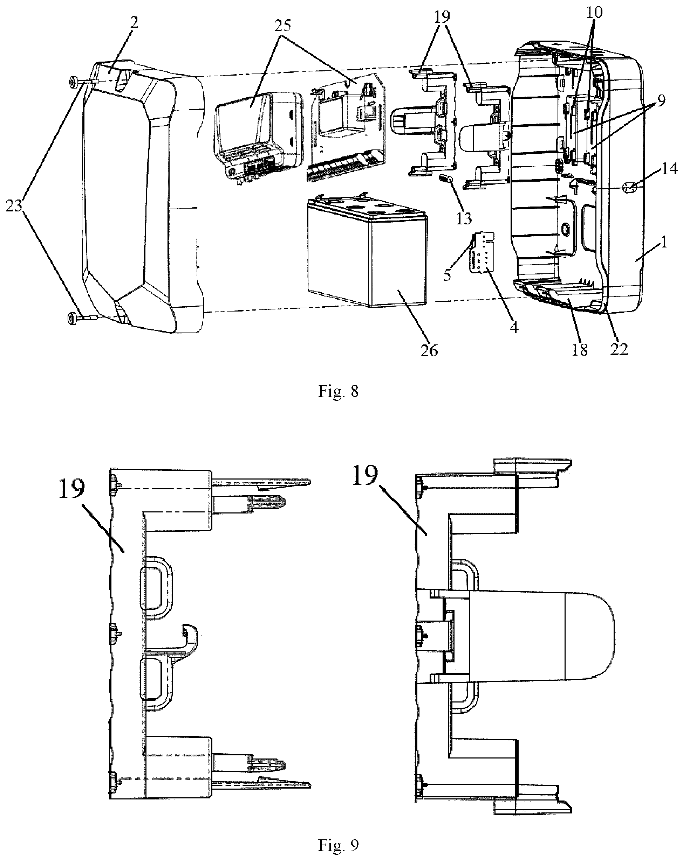

In order to mount at least one module 25 of the security system, the base 1 is provided with guides 9 with mechanical locks 10. The guides 9 also may be made as protruding studs, while the locks may be elastic latches which are coaxial thereto, as illustrated in Fig. 1 and Fig. 5. These guides 9 with the locks 10 are suitable for mounting expansion modules thereon, while substrates of the expansion modules are equipped with openings for the fastener. Also, the guides 9 may be made as longitudinal rails, while the locks 10 may be made as side or angular loops, as illustrated in Fig. 8. In this case, both expansion modules and bigger modules, e.g., hubs or switches, may be mounted on these guides 9 by sliding side parts of the modules along the guides. The illustrated exemplary embodiments of the guides and the fasteners allow to mount the modules into the box without use of any supplementary tools. Also, additional holders 19 may be fastened on the guides 9, and a modification thereof is illustrated in Fig. 9. The guides 9 may be provided both as a pair and in a greater amount, and they must be arranged in parallel to each other and in at least one row. The holders 19 reliably enter the fasteners 10 along the guides 9 and engage therewith, and to this end, a surface of the holders 19 that is engaged with the guides 9 must be equipped with corresponding interacting elements, e.g., wedge-type or groove-type elements. The protruding parts of the holders 19 may follow a shape of the guides 9 and the fasteners 10, thereby allowing to use them for varying the number, the distance and the position of the mounted modules in the box depending on their sizes, weight and configuration, etc.

Locations between the guides may be used to conveniently lay the cables, while their fixation may be performed by means of tie rods, and to this end, protruding loops 17 are provided on the inner surface of the base 1. Furthermore, a technological configuration of the loops 17 implies formation of slits at a place of their manufacturing, thereby ensuring a passive ventilation of the junction box.

In order to lay the cables to the box, the side walls of the base 1 are provided with recesses 14 for drilling openings, while an end wall of the base is provided with a through perforation 16. The perforated part 16 is necessary for laying the cables through a rear part of the base 1, while the recesses 14 for drilling are provided for laying and bringing out the cables sideways, from the bottom or from the top. In order to protect the modules 25 mounted in the box during the drilling, the inner part of the base 1 may be provided with safety protrusions 15 in an arrangement location of the recesses 14.

If battery-powered modules of the security system are arranged in the box, as illustrated in Fig. 8, the inner surface of at least one side wall of the base 1 may be provided with rectangular protruding elements 18 having upper edges that are equipped with openings for tightening fastening a battery 26 to the base, e.g., while passing a holding strip between said openings and loops 17.

The inner surface of the cover 2 may be provided with at least one abutment protrusion 20 that allows to further stabilize the position of the modules in the box.

Transverse reinforcing ribs 21 are provided at least along an inner perimeter of the base 1 and the protective cover 2, the ribs ensure resistance of the box against vibrations and impacts. Furthermore, the reinforcing ribs 21 may function as additional abutment elements for the modules 25 of the system, and to this end, they are made such that they protrude inside to a distance that is less or equal to a distance from the side walls of the base 1 to the arrangement location of at least one module 25.

The side walls of the base 1 and the cover 2 have profiled docking surfaces 22 to ensure firm abutment to each other. Therewith, shape and configuration of the docking surfaces 22 allow to mount the cover 2 on the base 1 in positions that are turned by an angle of 180 degrees, thereby allowing to vary both the arrangement of the junction box on the supporting surface and the fixation of the modules 25 inside thereof. The cover 2 is fixed on the base 1 by means of captive screws 23, while the base 1 is provided with recesses 24 for the captive screws.

The presence of the docking surfaces 22 and the captive screws 23 ensures firm abutment of the cover to the base and temporary retainment of the cover 2 until it is finally fixed on the base 1.

The surface-mountable junction box may be made substantially rectangular or square in a certain embodiment, as well as it may have various unit sizes depending on the required number of the security system modules to be mounted in the box, the number is from one to ten. Therewith, modifications of the shapes of the elements provided on the base and the cover disclosed both in independent claim in dependent claims of the claimed invention may be various and easily made by skilled persons without falling beyond the essence of the invention. The base and the cover, as well as their elements, should be made of a flameproof plastic by injection molding and, preferably, they should have a uniform textured surface. In order to allow monitoring of the modules that are equipped with light-indication elements, the cover may be made of a translucent plastic.

The claimed surface-mountable junction box is for mounting inside a room. Before mounting thereof, to ensure that a selected arrangement location is optimal, it is best to preliminary prepare a required number of openings for the cables by drilling them, e.g., with a hole saw for plastic, and inserting a corrugated pipe or a cable pathway into the formed opening. The base should be fastened on a selected surface using all existing openings for fastener, including the one that is within the weak section line that is for actuation of the tamper, if there is an attempt to dismount the box. One or more modules should be mounted on the guides with the locks or on the holders that are fastened on the guides with the locks. The cables of the modules should be laid and brought out through the existing openings or the through perforation of the base, and the cables then be fixed by means of the tie rods. The ribbon cable of the tamper board should be connected to a corresponding terminal of one of the modules. The cover is then mounted on the base and fastened by means of the captive screws. After the junction box is mounted, it does not require any user intervention and should be serviced only by technicians, if necessary.

Therefore, the claimed technical solution allows to create a junction box having the optimized space for convenient and reliable mounting and fixation of various modifications of the modules of the security system, while allowing its precise mounting on the mounting surface and reliable protection against unauthorized intervention.

### List of references in the Drawings:

- 1.: base
- 2.: protective cover
- 3.: mounting location of the tamper board
- 4.: tamper board
- 5.: tamper
- 6.: ribbon cable of the tamper board
- 7.: abutment location between the cover and the tamper
- 8.: weak section line
- 9.: guides
- 10.: mechanical locks
- 11.: openings for the fastener
- 12.: protrusions
- 13.: bubble level
- 14.: recesses for drilling the openings
- 15.: safety protrusions
- 16.: through perforation
- 17.: loops for tightening fastening
- 18.: rectangular protruding elements
- 19.: removable holders
- 20.: abutment protrusion
- 21.: reinforcing ribs
- 22.: profiled docking surfaces
- 23.: captive screws
- 24.: recesses for the captive screws
- 25.: module
- 26.: battery of the module

## Claims

1. A surface-mountable junction box that comprises a base (1) with elements for its positioning during mounting, a protective cover (2) that is configured to be connected to the base (1) and a protective element for protecting against an unauthorized intervention, and the base (1) is provided with locations for laying cables, **wherein** the positioning elements are through openings (11) for a fastener, while protrusions (12) are arranged along perimeters of the openings (11) on an external part of the base (1), **characterized in that** the protective element for protecting against unauthorized intervention comprises a tamper board (4) having a ribbon cable (6) that is configured to be connected to one of the security system modules (25), and the tamper board (4) is mounted in a space between one of side walls and an end wall of the base (1), while ensuring its firm abutment (7) to the protective cover (2) and to the end wall of the base (1), and part of the base (1) is provided with a weak section line (8) along a perimeter of the mounting location (3) of the tamper board (4);the locations for mounting at least one security system module (25) comprise a space that is delimited by guides (9) with mechanical locks(10) the weak section line (8) is provided around one of the openings (11) for the fastener.

2. The surface-mountable junction box according to claim 1, **wherein** the tamper board (4) comprises one tamper (5) that is mounted in an abutment zone of the protective cover (2).

3. The surface-mountable junction box according to claim 1, **wherein** the tamper board (4) comprises two tampers (5), where one tamper is mounted in an abutment zone of the protection cover (2), while another tamper is provided in an abutment zone between the board and the end wall of the base (1).

4. The surface-mountable junction box according to claim 1, further comprising an additional positioning element that is a bubble level (13) that is fastened in an inner part of the base (1).

5. The surface-mountable junction box according to claim 1, **wherein** the locations for laying the cables are provided in the side walls of the base (1) as recesses (14) for drilling openings and as a through perforation (16) in the end wall of the base (1).

6. The surface-mountable junction box according to claim 1, **wherein** an inner surface of the base (1) is provided with protruding loops (17) for a tightening fastener.

7. The surface-mountable junction box according to claim 1, **wherein** an inner surface of at least one side wall of the base (1) is provided with rectangular protruding elements (18), and upper edges of the protruding elements are equipped with openings (11) for a tightening fastener.

8. The surface-mountable junction box according to claim 1, **wherein** the guides (9) with mechanical locks (10) are arranged in parallel to each other in at least one row, while the locks (10) are configured to mount removable holders (19).

9. The surface-mountable junction box according to claim 1, **wherein** at least one abutment protrusion (20) is provided on an inner surface of the cover (2).

10. The surface-mountable junction box according to claim 1, **wherein** transverse reinforcing ribs (21) are provided at least along an inner perimeter of the base (1) and the protective cover (2).

11. The surface-mountable junction box according to claim 1, **wherein** the side walls of the base (1) and of the cover have profiled docking surfaces (22) that are configured to abut to each other in two positions turned by an angle of 180 degrees, while fastening elements of the cover (2) are captive screws (23).

## Patentansprüche

1. Oberflächenmontierbare Anschlussdose, die eine Basis (1) mit Elementen für ihre Positionierung während der Montage, eine Schutzabdeckung (2), die so konfiguriert ist, dass sie mit der Basis (1) verbunden werden kann, und ein Schutzelement zum Schutz vor unbefugtem Zugriff umfasst, und die Basis (1) ist mit Stellen zum Verlegen von Kabeln versehen, wobei die Positionierungselemente Durchgangsöffnungen (11) für ein Befestigungselement sind, während Vorsprünge (12) entlang der Umfänge der Öffnungen (11) an einem äußeren Teil der Basis (1) angeordnet sind,
**dadurch gekennzeichnet, dass** das Schutzelement zum Schutz vor unbefugtem Eingriff eine Manipulationsplatine (4) mit einem Flachbandkabel (6) umfasst, das so konfiguriert ist, dass es mit einem der Sicherheitssystemmodule (25) verbunden werden kann, und die Manipulationsplatine (4) in einem Raum zwischen einer der Seitenwände und einer Stirnwand der Basis (1) montiert ist, wobei ihr fester Anschlag (7) an der Schutzabdeckung (2) und an der Stirnwand der Basis (1) gewährleistet ist, und ein Teil der Basis (1) mit einer Schwachstelle (8) entlang eines Umfangs der Montageposition (3) der Manipulationsplatine (4) versehen ist; die Befestigungsstellen für mindestens ein Sicherheitssystemmodul (25) umfassen einen Raum, der durch Führungen (9) mit mechanischen Verriegelungen (10) begrenzt ist. Die Schwachstelle (8) ist um eine der Öffnungen (11) für das Befestigungselement herum vorgesehen.

2. Oberflächenmontierbare Anschlussdose gemäß Anspruch 1, **wobei** die Manipulationsplatine (4) eine Manipulationsvorrichtung (5) umfasst, die in einem Anschlagbereich der Schutzabdeckung (2) angebracht ist.

3. Oberflächenmontierbare Anschlussdose gemäß Anspruch 1, **wobei** die Manipulationsplatine (4) zwei Manipulationsvorrichtungen (5) umfasst, wobei eine Manipulationsvorrichtung in einem Anschlagbereich der Schutzabdeckung (2) angebracht ist, während eine weitere Manipulationsvorrichtung in einem Anschlagbereich zwischen der Platine und der Stirnwand der Basis (1) vorgesehen ist.

4. Oberflächenmontierbare Anschlussdose gemäß Anspruch 1, die ferner ein zusätzliches Positionierungselement umfasst, bei dem es sich um eine Wasserwaage (13) handelt, die in einem inneren Teil des Sockels (1) befestigt ist.

5. Oberflächenmontierbare Anschlussdose gemäß Anspruch 1, **wobei** die Stellen zum Verlegen der Kabel in den Seitenwänden der Basis (1) als Aussparungen (14) zum Bohren von Öffnungen und als Durchgangsperforation (16) in der Stirnwand der Basis (1) vorgesehen sind.

6. Oberflächenmontierbare Anschlussdose gemäß Anspruch 1, **wobei** eine Innenfläche der Basis (1) mit vorstehenden Schlaufen (17) für ein Spannbefestigungselement versehen ist.

7. Oberflächenmontierbare Anschlussdose gemäß Anspruch 1, **wobei** eine Innenfläche mindestens einer Seitenwand der Basis (1) mit rechteckigen vorstehenden Elementen (18) versehen ist und die Oberkanten der vorstehenden Elemente mit Öffnungen (11) für ein Befestigungselement ausgestattet sind.

8. Oberflächenmontierbare Anschlussdose gemäß Anspruch 1, **wobei** die Führungen (9) mit mechanischen Verriegelungen (10) parallel zueinander in mindestens einer Reihe angeordnet sind, während die Verriegelungen (10) so konfiguriert sind, dass sie abnehmbare Halterungen (19) befestigen.

9. Oberflächenmontierbare Anschlussdose gemäß Anspruch 1, **wobei** mindestens ein Anschlagvorsprung (20) an einer Innenfläche der Abdeckung (2) vorgesehen ist.

10. Oberflächenmontierbare Anschlussdose gemäß Anspruch 1, **wobei** quer verlaufende Verstärkungsrippen (21) mindestens entlang eines Innenumfangs der Basis (1) und der Schutzabdeckung (2) vorgesehen sind.

11. Oberflächenmontierbare Anschlussdose gemäß Anspruch 1, **wobei** die Seitenwände der Basis (1) und der Abdeckung profilierte Andockflächen (22) aufweisen, die so konfiguriert sind, dass sie in zwei um 180 Grad gedrehten Positionen aneinander anliegen, während die Befestigungselemente der Abdeckung (2) unverlierbare Schrauben (23) sind.

## Revendications

1. Une boîte de jonction montable en surface qui comprend une base (1) avec des éléments pour son positionnement pendant le montage, un couvercle de protection (2) qui est configuré pour être relié à la base (1) et un élément de protection pour protéger contre une intervention non autorisée, et la base (1) est pourvue d'emplacements pour la pose de câbles, dans laquelle les éléments de positionnement sont des ouvertures traversantes (11) pour une fixation, tandis que des saillies (12) sont disposées le long des périmètres des ouvertures (11) sur une partie externe de la base (1),
**caractérisé en ce que** l'élément de protection pour protéger contre toute intervention non autorisée comprend une plaque anti-effraction (4) comportant un câble ruban (6) qui est configuré pour être relié à l'un des modules du système de sécurité (25), et la plaque anti-effraction (4) est montée dans un espace entre l'une des parois latérales et une paroi d'extrémité de la base (1), tout en assurant sa butée ferme (7) contre le couvercle de protection (2) et contre la paroi d'extrémité de la base (1), et une partie de la base (1) est pourvue d'une ligne de section faible (8) le long d'un périmètre de l'emplacement de montage (3) de la plaque anti-effraction (4) ;les emplacements pour le montage d'au moins un module de système de sécurité (25) comprennent un espace délimité par des guides (9) avec des verrous mécaniques (10) la ligne de section faible (8) est prévue autour de l'une des ouvertures (11) pour la fixation.

2. La boîte de jonction montable en surface selon la revendication 1, **dans laquelle** la plaque anti-effraction (4) comprend un dispositif anti-effraction (5) qui est monté dans une zone de butée du couvercle de protection (2).

3. La boîte de jonction montable en surface selon la revendication 1, **dans laquelle** la plaque anti-effraction (4) comprend deux dispositifs anti-effraction (5), l'un étant monté dans une zone de butée du couvercle de protection (2), tandis que l'autre est prévu dans une zone de butée entre la plaque et la paroi d'extrémité de la base (1).

4. La boîte de jonction montable en surface selon la revendication 1, comprenant en outre un élément de positionnement supplémentaire qui est un niveau à bulle (13) qui est fixé dans une partie intérieure de la base (1).

5. La boîte de jonction montable en surface selon la revendication 1, **dans laquelle** les emplacements pour la pose des câbles sont prévus dans les parois latérales de la base (1) sous forme d'évidements (14) pour le perçage d'ouvertures et sous forme d'une perforation traversante (16) dans la paroi d'extrémité de la base (1).

6. La boîte de jonction montable en surface selon la revendication 1, **dans laquelle** une surface intérieure de la base (1) est pourvue de boucles saillantes (17) pour une fixation par serrage.

7. La boîte de jonction montable en surface selon la revendication 1, **dans laquelle** une surface intérieure d'au moins une paroi latérale de la base (1) est pourvue d'éléments saillants rectangulaires (18), et les bords supérieurs des éléments saillants sont équipés d'ouvertures (11) pour une fixation par serrage.

8. La boîte de jonction montable en surface selon la revendication 1, **dans laquelle** les guides (9) avec des verrous mécaniques (10) sont disposés parallèlement les uns aux autres en au moins une rangée, tandis que les verrous (10) sont configurés pour monter des supports amovibles (19).

9. La boîte de jonction montable en surface selon la revendication 1, **dans laquelle** au moins une saillie d'aboutement (20) est prévue sur une surface intérieure du couvercle (2).

10. La boîte de jonction montable en surface selon la revendication 1, **dans laquelle** des nervures de renfort transversales (21) sont prévues au moins le long d'un périmètre intérieur de la base (1) et du couvercle de protection (2).

11. La boîte de jonction montable en surface selon la revendication 1, **dans laquelle** les parois latérales de la base (1) et du couvercle présentent des surfaces d'accouplement profilées (22) qui sont configurées pour venir en butée l'une contre l'autre dans deux positions tournées d'un angle de 180 degrés, tandis que les éléments de fixation du couvercle (2) sont des vis imperdables (23).
